# EUROPEAN PATENT APPLICATION

(11) **EP 4 693 772 A1**
(43) Date of publication of application: **11.02.2026**
(21) Application number: 24778559.5
(22) Date of filing: 17.01.2024
(51) Int. Cl.: H01S 5/40, H01S 5/02255

(54) **LASER MODULE AND FIBER LASER DEVICE**

(30) Priority: 24.03.2023 JP 2023047820
(71) Applicant: FUJIKURA LTD., Koto-ku Tokyo 135-8512 (JP)
(72) Inventor: UCHIYAMA, Masahiro, Sakura-shi, Chiba 285-8550 (JP)
(74) Representative: Bardehle Pagenberg Partnerschaft mbB Patentanwälte Rechtsanwälte
(86) International application number: PCT/JP2024/001075
(87) International publication number: WO 2024/202413

(57) **Abstract**

A laser module that can be manufactured readily and at low cost is provided. A laser module 1 has first laser sections 21 including first semiconductor laser devices 11 capable of emitting first emission laser beams L₁ in the +X-direction, second laser sections 22 including second semiconductor laser devices 12 capable of emitting second emission laser beams L₂ in the -X-direction, first mirrors 51 configured to reflect the first emission laser beams L₁ toward a direction inclined with respect to a placement surface 5A of a base portion 5, second mirrors 52 configured to reflect the second emission laser beams L₂ toward a direction inclined with respect to the placement surface 5A of the base portion 5, a glass block 60 configured to generate parallel laser beams P₁ and P₂ from the emission laser beams L₁ and L₂, respectively, a beam splitter 64 configured to combine the parallel laser beams P₁ and P₂ into combined laser beams C, and a focusing portion 67 configured to focus and couple the combined laser beams C to an optical fiber 3. All of the laser sections 21 and 22 and the mirrors 51 and 52 are arranged on the placement surface 5A of the base portion 5.

## Description

### Technical Field

The present invention relates to a laser module and a fiber laser apparatus, and more particularly to a laser module that focuses and outputs laser beams emitted from a plurality of semiconductor laser devices.

### Background Art

There has heretofore been known a laser module that focuses laser beams emitted from a plurality of semiconductor laser devices to output a high-power laser beam (see, e.g., Patent Literature 1). Patent Literature 1 discloses a laser module that combines laser beams emitted from a first set of laser diodes (120) and laser beams emitted from a second set of laser diodes (120) by a polarization beam combination prism (142), focuses the combined laser beams to an optical fiber (174) by a focusing lens (170), and outputs the focused laser beams (see FIGS. 3a-3c). The laser module disclosed in Patent Literature 1 has a substrate (200) having recesses and projections. Reflection mirrors (162) are arranged on a recessed portion of the substrate (200) to reflect laser beams emitted from the respective laser diodes (120) toward directions inclined relative to a bottom surface of the recessed portion. The laser diodes (120) are disposed on an installation surface, which is located higher than a surface on which the reflection mirrors (162) are disposed. Thus, in the conventional laser module, the laser diodes and the reflection mirrors are arranged on different surfaces of the substrate (200) having recesses and projections. Accordingly, the substrate (200) needs recesses or projections to be formed therein and requires a sufficient thickness, which in turn increases the manufacturing cost.

### Prior Art Literature

### Patent Literature

Patent Literature 1: US 2018/0031850 A1

### Summary of the Invention

### Problem(s) to be Solved by the Invention

The present invention has been made in view of the above drawbacks in the prior art. It is, therefore, an object of the present invention to provide a laser module that can be manufactured readily and at low cost and a fiber laser apparatus including such a laser module.

### Means for Solving Problem(s)

According to a first aspect of the present invention, there is provided a laser module including an optical fiber; a base portion having a placement surface; a plurality of first laser sections each having a first semiconductor laser device arranged on the placement surface of the base portion and configured to emit a first emission laser beam along a first laser emission direction; a plurality of second laser sections each having a second semiconductor laser device arranged on the placement surface of the base portion and configured to emit a second emission laser beam along a second laser emission direction opposite to the first laser emission direction; a plurality of first mirrors each arranged on the placement surface of the base portion and configured to reflect the first emission laser beam emitted from the first semiconductor laser device of a corresponding one of the plurality of first laser sections, toward a direction inclined with respect to the placement surface of the base portion; a plurality of second mirrors each arranged on the placement surface of the base portion and configured to reflect the second emission laser beam emitted from the second semiconductor laser device of a corresponding one of the plurality of second laser sections, toward a direction inclined with respect to the placement surface of the base portion; an optical parallelization portion configured to generate first parallel laser beams propagating in a direction parallel to the placement surface of the base portion, from the first emission laser beams reflected by the plurality of first mirrors and generate second parallel laser beams propagating in a direction parallel to the placement surface of the base portion, from the second emission laser beams reflected by the plurality of second mirrors; an optical combiner portion configured to combine the first parallel laser beams and the second parallel laser beams with each other to generate combined laser beams; and a focusing portion configured to focus and couple the combined laser beams to the optical fiber.

According to a second aspect of the present invention, there is provided a fiber laser apparatus including at least one pumping light source including the aforementioned laser module; and an amplification optical fiber connected to the optical fiber of the laser module, the amplification optical fiber having a core to which rare earth ions have been doped.

### Brief Description of Drawings

**[****Fig. 1]** Fig. 1 is a perspective view schematically showing a laser module according to an embodiment of the present invention.
**[****Fig. 2]** Fig. 2 is a plan view of the laser module illustrated in Fig. 1, partially in section.
**[****Fig. 3]** Fig. 3 is a view schematically showing optical paths of laser beams reflected by first mirrors with dotted lines.
**[****Fig. 4]** Fig. 4 is a plan view of a laser module according to another embodiment of the present invention, partially in section.
**[****Fig. 5]** Fig. 5 is a schematic diagram showing an example of a fiber laser apparatus using a laser module according to the present invention

### Mode(s) for Carrying Out the Invention

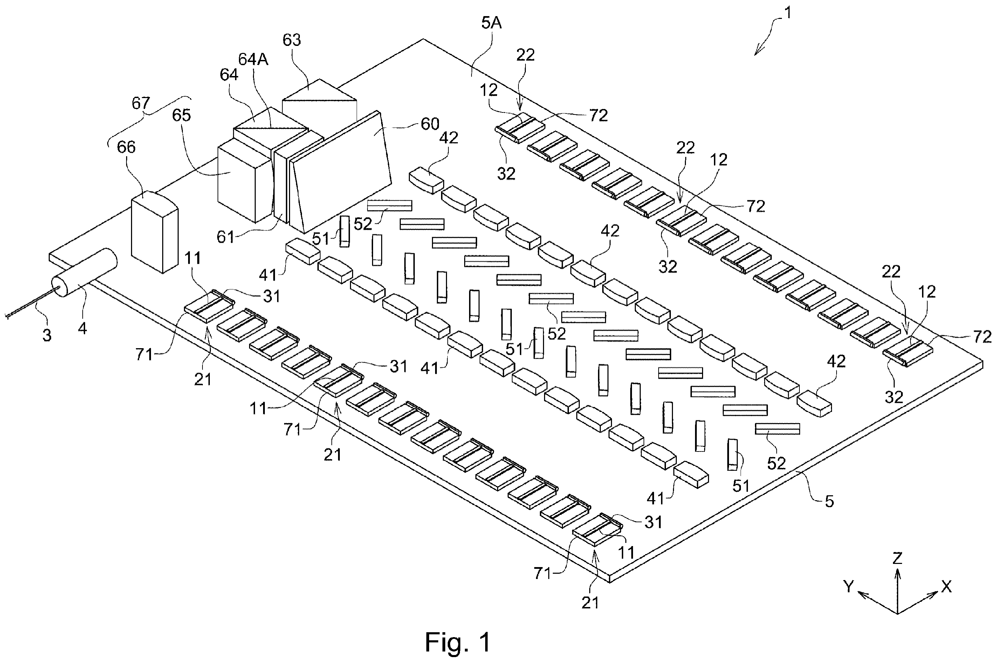

Embodiments of a laser module and a fiber laser apparatus according to the present invention will be described in detail below with reference to Figs. 1 to 5. In Figs. 1 to 5, the same or corresponding components are denoted by the same or corresponding reference numerals and will not be described below repetitively. Furthermore, in Figs. 1 to 5, the scales or dimensions of components may be exaggerated, and some components may be omitted. Unless mentioned otherwise, in the following description, terms such as "first," "second," and so forth are only used to distinguish one component from another and are not used to indicate a specific order or a specific sequence.

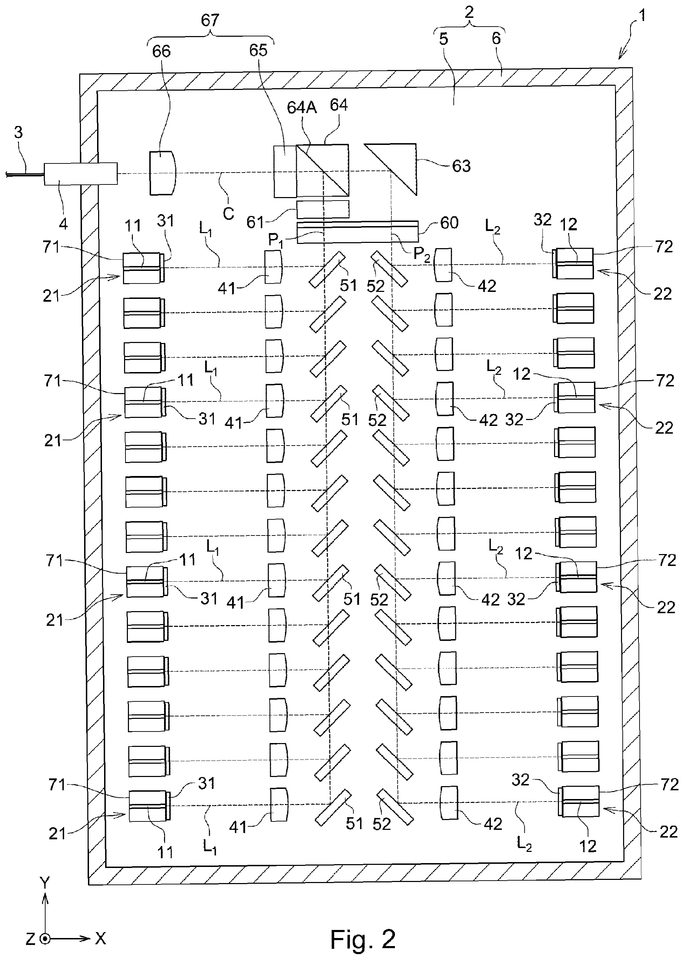

Fig. 1 is a perspective view schematically showing a laser module 1 according to an embodiment of the present invention, and Fig. 2 is a plan view of the laser module 1 partially in section. As illustrated in Figs. 1 and 2, the laser module 1 includes a plurality of first laser sections 21 each including a first semiconductor laser device 11 configured to emit a first emission laser beam L₁ in the +X-direction (first laser emission direction), a plurality of second laser sections 22 each including a second semiconductor laser device 12 configured to emit a second emission laser beam L₂ in the -X-direction (second laser emission direction), a housing 2 that houses therein optical components including the laser sections 21 and 22, an optical fiber 3 configured to output the laser beams from the laser section 21 and 22 to an exterior of the laser module 1, and a cylindrical fiber holder 4 that holds the optical fiber 3. Unless otherwise mentioned in the present embodiments, the term "downstream" refers to a direction in which a laser beam propagates from each of the semiconductor laser devices 11 and 12 toward the optical fiber 3, and the term "upstream" refers to an opposite direction thereto. In the present embodiments, for the sake of convenience, the +Z-direction in Fig. 1 is referred to as "upper" or "upward," and the -Z-direction is referred to as "lower" or "downward."

The housing 2 includes a base portion 5 in the form of a plate and sidewalls 6 extending from outer peripheral edges of the base portion 5 in the +Z-direction. For ease of understanding, the sidewalls 6 are omitted from the illustration in Fig. 1. A cover member, which is not shown in the drawings, is disposed on the +Z side of the sidewall 6 of the housing 2, and an interior space of the housing 2 is sealed by the cover member. In the present embodiment, 13 first laser sections 21 are arranged at equal intervals along the Y-direction on an upper surface 5A (placement surface) of the base portion 5 of the housing 2. Furthermore, 13 second laser sections 22 are arranged at equal intervals along the Y-direction on the placement surface 5A of the base portion 5 so as to face the set of the first laser sections 21.

Each of the first laser sections 21 of the present embodiment includes a first laser mount 71 having an upper surface on which the first semiconductor laser device 11 is fixed by soldering or the like. Thus, each of the first semiconductor laser devices 11 is fixed to the base portion 5 via the corresponding first laser mount 71. Each of the first laser mounts 71 serves as a stage for adjusting the height of the corresponding first semiconductor laser device 11 in the Z-direction. The first laser mounts 71 are fixed to the base portion 5 by, for example, soldering. Similarly, each of the second laser sections 22 includes a second laser mount 72 having an upper surface on which the second semiconductor laser device 12 is fixed by soldering or the like. Each of the second semiconductor laser devices 12 is fixed to the base portion 5 via the corresponding second laser mount 72. Each of the second laser mounts 72 serves as a stage for adjusting the height of the corresponding second semiconductor laser device 12 in the Z-direction. The second laser mounts 72 are fixed to the base portion 5 by, for example, soldering. The laser mounts 71 and 72 may be omitted when no height adjustment is required for the first semiconductor laser devices 11 and the second semiconductor laser devices 12.

The laser module 1 includes first fast-axis collimator lenses 31, first slow-axis collimator lenses 41, and first mirrors 51 provided so as to correspond to the first semiconductor laser devices 11 of the first laser sections 21. The first fast-axis collimator lenses 31 are configured to collimate, in the fast-axis direction, the first emission laser beams L₁ emitted from the first semiconductor laser devices 11, the first slow-axis collimator lenses 41 are configured to collimate, in the slow-axis direction, the first emission laser beams L₁ that have passed through the first fast-axis collimator lenses 31, and the first mirrors 51 are configured to reflect the first emission laser beams L₁ that have passed through the first slow-axis collimator lenses 41 toward the +Y-direction. The first fast-axis collimator lenses 31, the first slow-axis collimator lenses 41, and the first mirrors 51 are arranged on the placement surface 5A of the base portion 5, as with the first laser sections 21. In the present embodiment, each of the first emission laser beams L₁ includes a TE mode, as a major polarization component, and a TM mode, as a minor polarization component. The power of the TM mode (minor polarization component) of the first emission laser beams L₁ is approximately 1 % to 5 % of the power of the TE mode (major polarization component).

Furthermore, the laser module 1 includes second fast-axis collimator lenses 32, second slow-axis collimator lenses 42, and second mirrors 52 provided so as to correspond to the second semiconductor laser devices 12 of the second laser sections 22. The second fast-axis collimator lenses 32 are configured to collimate, in the fast-axis direction, the second emission laser beams L₂ emitted from the second semiconductor laser devices 12, the second slow-axis collimator lenses 42 are configured to collimate, in the slow-axis direction, the second emission laser beams L₂ that have passed through the second fast-axis collimator lenses 32, and the second mirrors 52 are configured to reflect the second emission laser beams L₂ that have passed through the second slow-axis collimator lenses 42 toward the +Y-direction. The second fast-axis collimator lenses 32, the second slow-axis collimator lenses 42, and the second mirrors 52 are arranged on the placement surface 5A of the base portion 5, as with the second laser sections 22. In the present embodiment, each of the second emission laser beams L₂ includes a TE mode, as a major polarization component, and a TM mode, as a minor polarization component, as with the first emission laser beams L₁. The power of the TM mode (minor polarization component) of the second emission laser beams L₂ is approximately 1 % to 5 % of the power of the TE mode (major polarization component).

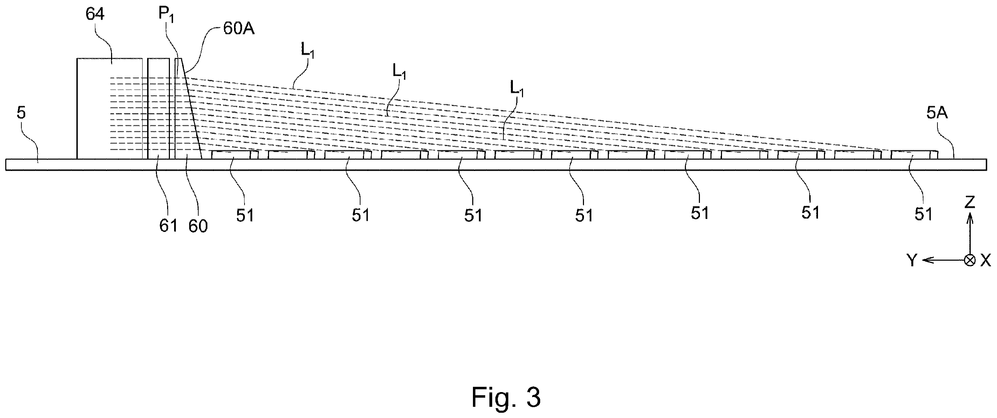

Fig. 3 schematically shows optical paths of the first emission laser beams L₁ reflected by the first mirrors 51 with dotted lines. As illustrated in Fig. 3, the first mirrors 51 are configured to reflect the first emission laser beams L₁ emitted from the first semiconductor laser devices 11 in directions inclined toward the +Z-direction with respect to the placement surface 5A of the base portion 5. In the present embodiment, all reflection surfaces of the first mirrors 51 are arranged in parallel to each other, so that the first emission laser beams L₁ that have been reflected by the respective first mirrors 51 propagate in parallel to each other. Similarly, although not illustrated in the drawings, the second mirrors 52 are configured to reflect the second emission laser beams L₂ emitted from the second semiconductor laser devices 12 in directions inclined toward the +Z-direction with respect to the placement surface 5A of the base portion 5. In the present embodiment, all reflection surfaces of the second mirrors 52 are arranged in parallel to each other, so that the second emission laser beams L₂ that have been reflected by the respective second mirrors 52 propagate in parallel to each other. The first mirrors 51 and the second mirrors 52 are not limited to the illustrated structures and may have any configuration as long as they are configured to reflect the first emission laser beams L₁ and the second emission laser beams L₂, respectively, in directions inclined toward the +Z-direction with respect to the placement surface 5A of the base portion 5.

As shown in Figs. 1 to 3, the laser module 1 has a glass block 60, which generates parallel laser beams propagating in parallel to the placement surface 5A from the first emission laser beams L₁ reflected in the directions inclined with respect to the placement surface 5A of the base portion 5 by the first mirrors 51 and the second emission laser beams L₂ reflected in the directions inclined with respect to the placement surface 5A of the base portion 5 by the second mirrors 52. This glass block 60 is arranged, on the placement surface 5A, on the +Y side of the first mirrors 51 and the second mirrors 52. The glass block 60 has an incidence surface 60A inclined with respect to the placement surface 5A. The incidence surface 60A of the glass block 60 is configured such that the first emission laser beams L₁ reflected by the respective first mirrors 51 and the second emission laser beams L₂ reflected by the respective second mirrors 52 are incident on the incidence surface 60A. The respective first emission laser beams L₁ entering the glass block 60 are refracted by the glass block 60 to form first parallel laser beams P₁, which are parallel to the placement surface 5A. The respective second emission laser beams L₂ entering the glass block 60 are refracted by the glass block 60 to form second parallel laser beams P₂, which are parallel to the placement surface 5A. In this manner, the glass block 60 of the present embodiment serves as an optical parallelization portion that generates first parallel laser beams P₁ propagating in a direction parallel to the placement surface 5A from the first emission laser beams L₁ reflected by the first mirrors 51 and also generates second parallel laser beams P₂ propagating in a direction parallel to the placement surface 5A from the second emission laser beams L₂ reflected by the second mirrors 52. In the present embodiment, the optical parallelization portion is formed by a single glass block 60 (single member). Therefore, the number of steps of arranging a glass block can be reduced as compared to a case where separate glass blocks are arranged for the first emission laser beams L₁ reflected by the first mirrors 51 and the second emission laser beams L₂ reflected by the second mirrors 52, respectively. Accordingly, a period of time required to manufacture the laser module 1 can be shortened.

The laser module 1 also has a half-wave plate 61 that rotates polarization orientations of the first parallel laser beams P₁, which have been parallelized by the glass block 60, through 90°. The half-wave plate 61 is arranged, on the placement surface 5A, on the +Y side of the glass block 60. The half-wave plate 61 is configured such that the first parallel laser beams P₁ parallelized by the glass block 60 are incident on the half-wave plate 61. The polarization orientations of the first parallel laser beams P₁ are rotated through 90° by the half-wave plate 61. Therefore, the polarization orientations of the major polarization component and the minor polarization component of each of the first parallel laser beams P₁ are rotated through 90° when the first parallel laser beams P₁ pass through the half-wave plate 61.

As illustrated in Figs. 1 and 2, the laser module 1 has an auxiliary mirror 63 configured to reflect the second parallel laser beams P₂. This auxiliary mirror 63 is arranged, on the placement surface 5A, on the +Y side of the glass block 60. The auxiliary mirror 63 is configured such that the second parallel laser beams P₂ parallelized by the glass block 60 are incident on the auxiliary mirror 63. The second parallel laser beams P₂ propagating in the +Y-direction are reflected toward the -X-direction by the auxiliary mirror 63.

As shown in Figs. 1 to 3, the laser module 1 has a beam splitter 64 configured to split two polarization components (the major polarization component and the minor polarization component) of each of the parallel laser beams P₁ and P₂ into different directions. This beam splitter 64 is arranged, on the placement surface 5A, on the +Y side of the half-wave plate 61 and on the -X side of the auxiliary mirror 63. The beam splitter 64 of the present embodiment is formed of two right-angle prisms. Each of the two right-angle prisms has an inclined surface that is inclined at an angle of 45° with respect to the X-direction and the Y-direction. The inclined surfaces of the two right-angle prisms are abutted on each other to form the beam splitter 64. An optical thin film 64A of a multilayer dielectric film, a thin metal film, or the like is formed on either one of those inclined surfaces. According to this configuration, a polarized wave that is horizontal to the optical thin film 64A is reflected by the optical thin film 64A and thus deflected by 90°, whereas a polarized wave that is vertical to the optical thin film 64A is transmitted through the optical thin film 64A.

The beam splitter 64 is configured such that the first parallel laser beams P₁ that have been transmitted through the half-wave plate 61 and the second parallel laser beams P₂ that have been reflected by the auxiliary mirror 63 are incident on the beam splitter 64. As described above, the polarization orientation of the major polarization components of the first parallel laser beams P₁ that have passed through the half-wave plate 61 has been rotated through 90°. Therefore, the major polarization components become horizontal to the optical thin film 64A of the beam splitter 64. Accordingly, the major polarization components of the first parallel laser beams P₁ are reflected by the optical thin film 64A of the beam splitter 64 and deflected by 90° to propagate in the -X-direction. Since the polarization orientation oof the minor polarization components of the parallel laser beams P₁ that have passed through the half-wave plate 61 has been rotated through 90°, the minor polarization components of the first parallel laser beams P₁ become vertical to the optical thin film 64A of the beam splitter 64. Accordingly, the minor polarization components of the first parallel laser beams P₁ are transmitted through the optical thin film 64A of the beam splitter 64 to propagate in the +X-direction.

Furthermore, the major polarization components of the second parallel laser beams P₂ that have reflected by the auxiliary mirror 63 are a TE mode and are vertical to the optical thin film 64A of the beam splitter 64. Accordingly, the major polarization components of the second parallel laser beams P₂ entering the beam splitter 64 are transmitted through the optical thin film 64A to propagate in the -Y-direction. The minor polarization components of the second parallel laser beams P₂ are a TM mode and are horizontal to the optical thin film 64A. Accordingly, the minor polarization components of the second parallel laser beam P₂ entering the beam splitter 64 is reflected by the optical thin film 64A and deflected by 90° to propagate in the +Y-direction.

In this manner, when the first parallel laser beams P₁, which are generated by parallelization of the first emission laser beams L₁ from the first semiconductor laser devices 11, and the second parallel laser beams P₂, which are generated by parallelization of the second emission laser beams L₂ from the second semiconductor laser devices 12, travel through the beam splitter 64, the major polarization components of the first parallel laser beams P₁ reflected by the optical thin film 64A and the major polarization components of the second parallel laser beams P₂ transmitted through the optical thin film 64A are combined with each other to generate combined laser beams C as combined major polarization components, which propagate in the -X-direction. Thus, the beam splitter 64 of the present embodiment serves as an optical combiner portion that combines the major polarization components of the first parallel laser beams P₁ and the major polarization components of the second parallel laser beams P₂ into combined laser beams C. The minor polarization components of the first parallel laser beams P₁ that have been transmitted through the optical thin film 64A and the minor polarization components of the second parallel laser beams P₂ that have been reflected by the optical thin film 64A are combined into combined minor polarization components, which propagate in the +Y-direction. For example, optical components such as a dichroic mirror may be used for the optical combiner portion, instead of the beam splitter 64 in the present embodiment.

As shown in Figs. 1 and 2, the laser module 1 has a focusing portion 67 configured to focus and couple the combined laser beams C (major polarization components) combined by the beam splitter 64 into the optical fiber 3. This focusing portion 67 includes a fast-axis focusing lens 65 configured to focus the combined laser beams C in the fast-axis direction and a slow-axis focusing lens 66 configured to focus the combined laser beams C in the slow-axis direction and couple the focused laser beams onto an end surface of the optical fiber 3. The fast-axis focusing lens 65 is arranged, on the placement surface 5A, on the -X side of the beam splitter 64. The slow-axis focusing lens 66 is arranged, on the placement surface 5A, on the -X side of the fast-axis focusing lens 65. The fast-axis focusing lens 65 is configured such that the combined laser beams C combined by the beam splitter 64 are incident on the fast-axis focusing lens 65. Thus, the combined laser beams C are focused in the fast-axis direction by the fast-axis focusing lens 65. The slow-axis focusing lens 66 is configured such that the combined laser beams C transmitted through the fast-axis focusing lens 65 are incident on the slow-axis focusing lens 66. Thus, the combined laser beams C are focused in the slow axis direction and coupled onto the end surface of the optical fiber 3 by the slow-axis focusing lens 66. The combined laser beams C that have been coupled to the optical fiber 3 propagate through a core of the optical fiber, so that the combined laser beams C are outputted to an exterior of the housing 2.

As described above, according to the laser module 1 of the present embodiment, the first mirrors 51 are arranged on the same plane (the placement surface 5A of the base portion 5) as the plane on which the first laser sections 21 are arranged. The second mirrors 52 are arranged on the same plane (the placement surface 5A of the base portion 5) as the plane on which the second laser sections 22 are arranged. Thus, the first laser sections 21, the second laser sections 22, the first mirrors 51, and the second mirrors 52 are all arranged on the same plane (the placement surface 5A) of the base portion 5. Therefore, no recesses or projections are required to arrange the first laser sections 21, the second laser sections 22, the first mirrors 51, and the second mirrors 52 on the base portion 5. Accordingly, no steps of forming recesses or projections in the base portion 5 (cutting the base portion 5) are required, and the base portion 5 can be thinned. Additionally, the height of the first mirrors 51 and the second mirrors 52 along the Z-direction can be reduced. As a result, the laser module 1 can be manufactured with ease at low cost.

Furthermore, in the present embodiment, the glass block 60 (the optical parallelization portion), the beam splitter 64 (the optical combiner portion), and the focusing portion 67 (the fast-axis focusing lens 65 and the slow-axis focusing lens 66) are also arranged on the same plane (the placement surface 5A) of the base portion 5, in addition to the first laser sections 21, the second laser sections 22, the first mirrors 51, and the second mirrors 52. Therefore, no recesses or projections are required to arrange those components on the base portion 5. As the auxiliary mirror 63 is also arranged on the same plane (the placement surface 5A) of the base portion 5, no recesses or projections are required to arrange the auxiliary mirror 63 on the base portion 5. Accordingly, no steps of forming recesses or projections in the base portion 5 (cutting the base portion 5) are required, and the base portion 5 can be thinned. Additionally, the height of the first mirrors 51 and the second mirrors 52 along the Z-direction can be reduced. As a result, the laser module 1 can be manufactured readily and at low cost.

In the present embodiment, as shown in Fig. 2, the first semiconductor laser devices 11 of the first laser sections 21 and the second semiconductor laser devices 12 of the second laser sections 22 are arranged symmetrically with respect to the YZ-plane. The optical axes of the first emission laser beam L₁ and the second emission laser beam L₂ emitted from the symmetrically positioned first and second semiconductor laser devices 11 and 12 lie on the same line. When the optical axes of the first emission laser beam L₁ and the second emission laser beam L₂ emitted from the corresponding first and second semiconductor laser devices 11 and 12 do not line on the same line, as illustrated in Fig. 3a of Patent Literature 1, then the intervals between the adjacent first laser sections 21 along the Y-direction and the intervals between the adjacent second laser sections 22 along the Y-direction need to be increased. However, when the optical axes of the first emission laser beam L₁ and the second emission laser beam L₂ emitted from the symmetrically positioned first and second semiconductor laser devices 11 and 12 lie on the same line, as in the present embodiment, the intervals between the adjacent first laser sections 21 along the Y-direction and the intervals between the adjacent second laser sections 22 along the Y-direction can be reduced. Accordingly, the length of the base portion 5 along the Y-direction can be reduced, which in turn reduces the manufacturing cost. Simultaneously, as the optical paths of the laser beams from the semiconductor laser devices 11 and 12 to the optical fiber 3 are shortened, the coupling efficiency of the laser beams to the optical fiber 3 can also be improved.

As described above, the first semiconductor laser devices 11 of the first laser sections 21 and the second semiconductor laser devices 12 of the second laser sections 22 are arranged symmetrically with respect to the YZ-plane. Therefore, an optical path length from one first semiconductor laser device 11 to the glass block 60 is equal to an optical path length from a second semiconductor laser device 12 located symmetrically with respect to that first semiconductor laser device 11 to the glass block 60. Thus, laser beams having equal optical path lengths to the glass block 60 are combined by the beam splitter 64, resulting in improved beam quality of the laser beams that have coupled to the optical fiber 3.

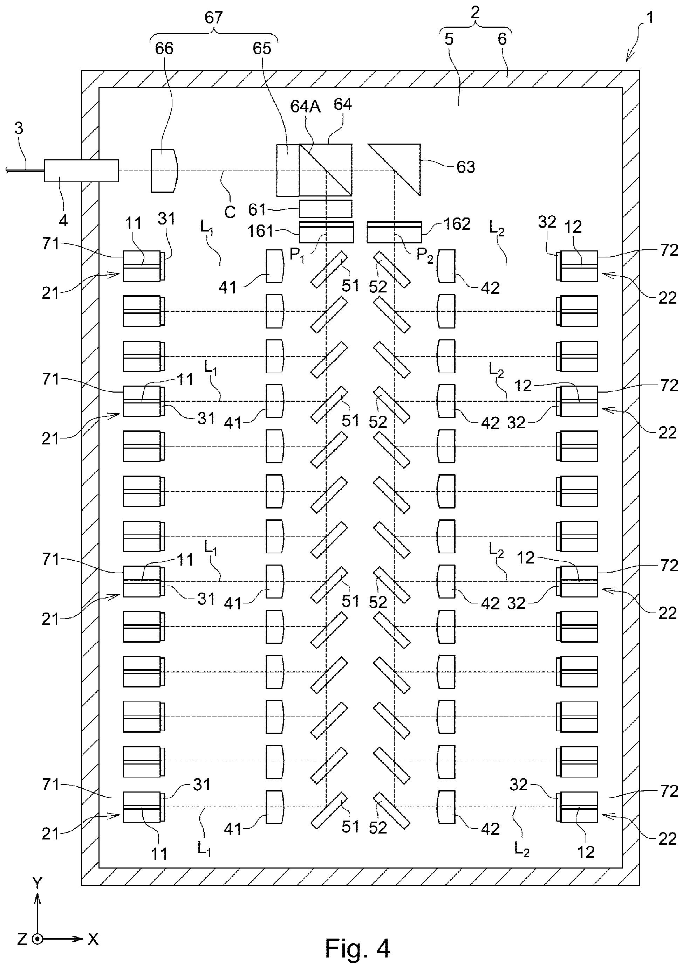

In the example illustrated in Fig. 2, the first emission laser beams L₁ emitted from the first semiconductor laser devices 11 of the first laser sections 21 and the second emission laser beams L₂ emitted from the second semiconductor laser devices 12 of the second laser sections 22 are incident on the same glass block 60. As shown in Fig. 4, however, a first glass block 161, which generates the first parallel laser beams P₁ from the first emission laser beams L₁ that have been emitted from the first semiconductor laser devices 11 of the first laser sections 21 and reflected by the first mirrors 51, and a second glass block 162, which generates the second parallel laser beams P₂ from the second emission laser beams L₂ that have been emitted from the second semiconductor laser devices 12 of the second laser sections 22 and reflected by the second mirrors 52, may be arranged on the placement surface 5A of the base portion 5, instead of the single glass block 60. In this case, these two glass blocks 161 and 162 jointly form an optical parallelization portion, which generates first parallel laser beams P₁ propagating in a direction parallel to the placement surface 5A, from the first emission laser beams L₁ reflected by the first mirrors 51 and generates second parallel laser beams P₂ propagating in a direction parallel to the placement surface 5A, from the second emission laser beams L₂ reflected by the second mirrors 52. Additionally, the auxiliary mirror 63 may be arranged upstream of the glass block 162 when the optical parallelization portion is thus formed by a plurality of glass blocks 161 and 162.

In the aforementioned embodiment, there has been described an example where the major polarization components of the laser beams emitted from the semiconductor laser devices 11 and 12 are combined with each other. Nevertheless, the present invention is not limited to such a configuration of polarization combining. The present invention is applicable to any laser module configured to combine laser beams propagating through two optical paths, irrespective of the manner of combining the laser beams.

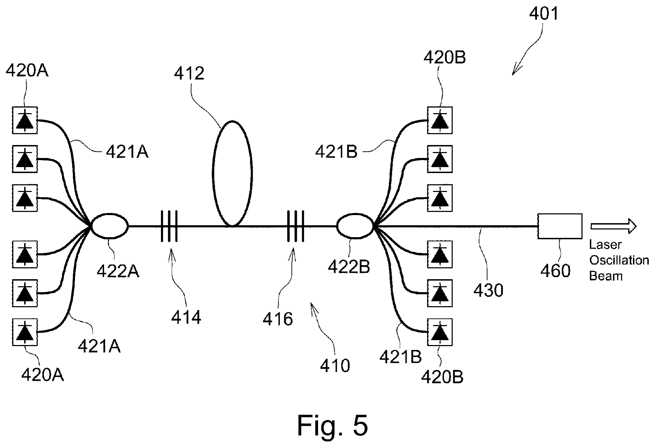

For example, the aforementioned laser module 1 can be used for a fiber laser apparatus and the like. Fig. 5 is a schematic diagram showing an example of a fiber laser apparatus using a laser module according to the present invention. The fiber laser apparatus 401 illustrated in Fig. 5 has an optical cavity 410, a plurality of forward pumping light sources 420A operable to introduce pumping light into the optical cavity 410 from a front side of the optical cavity 410, a forward in-line combiner 422A connected to those forward pumping light sources 420A via optical fibers 421A, a plurality of backward pumping light sources 420B operable to introduce pumping light into the optical cavity 410 from a back side of the optical cavity 410, and a backward in-line combiner 422B connected to those backward pumping light sources 420B via optical fibers 421B. The aforementioned laser module 1 can be used as the forward pumping light sources 420A and the backward pumping light sources 420B.

The optical cavity 410 includes an amplification optical fiber 412 having a core to which rare earth ions such as ytterbium (Yb), erbium (Er), thulium (Tr), or neodymium (Nd) have been doped, a high-reflectivity fiber Bragg grating (high-reflectivity FBG) 414 connected to the amplification optical fiber 412 and the forward in-line combiner 422A, and a low-reflectivity fiber Bragg grating (low-reflectivity FBG) 416 connected to the amplification optical fiber 412 and the backward in-line combiner 422B. For example, the amplification optical fiber 412 is formed of a double cladding optical fiber having an inner cladding formed around a core and an outer cladding formed around the inner cladding.

The fiber laser apparatus 401 also has a delivery fiber 430 extending from the backward in-line combiner 422B. A laser output portion 460 for emitting a laser oscillation beam from the amplification optical fiber 412 to, for example, a workpiece is provided on a downstream end of the delivery fiber 430

The forward in-line combiner 422A and the backward in-line combiner 422B are configured to combine pumping light outputted from the forward pumping light sources 420A and the backward pumping light sources 420B, respectively, and introduce the combined pumping light to the inside of the aforementioned inner cladding of the amplification optical fiber 412. Thus, the pumping light propagates within the inner cladding of the amplification optical fiber 412.

The high-reflectivity FBG 414 is formed of an optical fiber having refractive indexes varying in a periodical manner. The high-reflectivity FBG 414 reflects light having a certain wavelength range at a reflectivity near 100 %. As with the high-reflectivity FBG 414, the low-reflectivity FBG 416 is formed of an optical fiber having refractive indexes varying in a periodical manner. The low-reflectivity FBG 416 allows a portion of light having the wavelength range that is to be reflected by the high-reflectivity FBG 414 to pass therethrough and reflects the rest of the light. Thus, the high-reflectivity FBG 414, the amplification optical fiber 12, and the low-reflectivity FBG 416 form the optical cavity 410, which recursively amplifies light having a specific wavelength range between the high-reflectivity FBG 414 and the low-reflectivity FBG 416 to cause laser oscillation.

In the example illustrated in Fig. 5, the pumping light sources 420A and 420B and the combiners 422A and 422B are provided on a side of the high-reflectivity FBG 414 and a side of the low-reflectivity FBG 416 so as to form a bidirectional pumping fiber laser apparatus. However, one or more pumping light sources and an optical combiner may be provided only on either one of the side of the high-reflectivity FBG 414 and the side of the low-reflectivity FBG 416. Mirrors may be used as a reflection means for causing laser oscillation within the optical cavity 410, instead of the FBGs.

As a fiber laser apparatus, there has been known a MOPA fiber laser apparatus that amplifies seed light from a seed light source with use of pumping light from a pumping light source. The aforementioned laser module may be used as a pumping light source of such a MOPA fiber laser apparatus.

As described above, according to a laser module of the present invention, the first mirrors are arranged on the same surface (the placement surface of the base portion) as the surface on which the first laser sections are arranged. The second mirrors are arranged on the same surface (the placement surface of the base portion) as the surface on which the second laser sections are arranged. Thus, all of the first laser sections, the second laser sections, the first mirrors, and the second mirrors are arranged on the same plane (the placement surface) of the base portion. Therefore, no recesses or projections are required to arrange the first laser sections, the second laser sections, the first mirrors, and the second mirrors on the base portion. Accordingly, no steps of forming recesses or projections in the base portion (cutting the base portion) are required, and the base portion can be thinned. Additionally, the height of the first mirrors and the second mirrors can be reduced. As a result, the laser module can be manufactured readily and at low cost.

A laser module according to the present invention can adopt the following configurations:

### (Configuration 1)

A laser module includes an optical fiber; a base portion having a placement surface; a plurality of first laser sections each having a first semiconductor laser device arranged on the placement surface of the base portion and configured to emit a first emission laser beam along a first laser emission direction; a plurality of second laser sections each having a second semiconductor laser device arranged on the placement surface of the base portion and configured to emit a second emission laser beam along a second laser emission direction opposite to the first laser emission direction; a plurality of first mirrors each arranged on the placement surface of the base portion and configured to reflect the first emission laser beam emitted from the first semiconductor laser device of a corresponding one of the plurality of first laser sections, toward a direction inclined with respect to the placement surface of the base portion; a plurality of second mirrors each arranged on the placement surface of the base portion and configured to reflect the second emission laser beam emitted from the second semiconductor laser device of a corresponding one of the plurality of second laser sections, toward a direction inclined with respect to the placement surface of the base portion; an optical parallelization portion configured to generate first parallel laser beams propagating in a direction parallel to the placement surface of the base portion, from the first emission laser beams reflected by the plurality of first mirrors and generate second parallel laser beams propagating in a direction parallel to the placement surface of the base portion, from the second emission laser beams reflected by the plurality of second mirrors; an optical combiner portion configured to combine the first parallel laser beams and the second parallel laser beams with each other to generate combined laser beams; and a focusing portion configured to focus and couple the combined laser beams to the optical fiber.

### (Configuration 2)

In the laser module of Configuration 1, an optical path length from the first semiconductor laser device of each of the plurality of first laser sections to the optical parallelization portion is equal to an optical path length from the second semiconductor laser device of a corresponding one of the plurality of second laser sections to the optical parallelization portion.

### (Configuration 3)

In the laser module of Configuration 1 or 2, an optical axis of the first emission laser beam emitted from the first semiconductor laser device of each of the plurality of first laser sections lies on a same line as an optical axis of the second emission laser beam emitted from the second semiconductor laser device of a corresponding one of the plurality of second laser sections.

### (Configuration 4)

In the laser module of any one of Configurations 1 to 3, the optical parallelization portion is formed of a single member.

### (Configuration 5)

In the laser module of any one of Configurations 1 to 4, the optical parallelization portion, the optical combiner portion, and the focusing portion are arranged on the placement surface of the base portion.

### (Configuration 6)

The laser module of any one of Configurations 1 to 5 further includes an auxiliary mirror configured to reflect the second emission laser beams or the second parallel laser beams toward the optical combiner portion.

Furthermore, a fiber laser apparatus according to the present invention can adopt the following configuration:

### (Configuration 7)

A fiber laser apparatus includes at least one pumping light source including the laser module of any one of Configurations 1 to 6; and an amplification optical fiber connected to the optical fiber of the laser module, the amplification optical fiber having a core to which rare earth ions have been doped.

Although some preferred embodiments of the present invention have been described, the present invention is not limited to the aforementioned embodiments. It should be understood that various different forms may be applied to the present invention within the technical idea thereof.

This application claims the benefit of priority from Japanese patent application No. 2023-047820, filed on March 24, 2023, the disclosure of which is incorporated herein in its entirety by reference.

### Industrial Applicability

The present invention is suitably used for a laser module that focuses laser beams emitted from a plurality of semiconductor laser devices and outputs the focused laser beams.

### Description of Reference Numerals and Signs

- 1: Laser module

- 2: Housing
- 3: Optical fiber
- 4: Fiber holder
- 5: Base portion
- 5A: Placement surface
- 6: Sidewall
- 11: First semiconductor laser device
- 12: Second semiconductor laser device
- 21: First laser section
- 22: Second laser section
- 31: First fast-axis collimator lens
- 32: Second fast-axis collimator lens
- 41: First slow-axis collimator lens
- 42: Second slow-axis collimator lens
- 51: First mirror
- 52: Second mirror
- 60: Glass block (optical parallelization portion)
- 60A: Incidence surface
- 61: Half-wave plate
- 63: Auxiliary mirror
- 64: Beam splitter (optical combiner portion)
- 65: Fast-axis focusing lens
- 66: Slow-axis focusing lens
- 67: Focusing portion
- 161: First glass block
- 162: Second glass block
- 401: Fiber laser apparatus
- 410: Optical cavity
- 412: Amplification optical fiber
- 414: High-reflectivity FBG
- 416: Low-reflectivity FBG
- 420A: Forward pumping light sources
- 420B: Backward pumping light sources
- 421A, 421B: Optical fiber
- 422A: Forward in-line combiner
- 422B: Backward in-line combiner
- 430: Delivery fiber
- 460: Laser output portion
- C: Combined laser beam
- L₁: First emission laser beam
- L₂: Second emission laser beam
- P₁: First parallel laser beam
- P₂: Second parallel laser beam

## Claims

1. A laser module comprising:
an optical fiber;
a base portion having a placement surface;
a plurality of first laser sections each having a first semiconductor laser device arranged on the placement surface of the base portion and configured to emit a first emission laser beam along a first laser emission direction;
a plurality of second laser sections each having a second semiconductor laser device arranged on the placement surface of the base portion and configured to emit a second emission laser beam along a second laser emission direction opposite to the first laser emission direction;
a plurality of first mirrors each arranged on the placement surface of the base portion and configured to reflect the first emission laser beam emitted from the first semiconductor laser device of a corresponding one of the plurality of first laser sections, toward a direction inclined with respect to the placement surface of the base portion;
a plurality of second mirrors each arranged on the placement surface of the base portion and configured to reflect the second emission laser beam emitted from the second semiconductor laser device of a corresponding one of the plurality of second laser sections, toward a direction inclined with respect to the placement surface of the base portion;
an optical parallelization portion configured to generate first parallel laser beams propagating in a direction parallel to the placement surface of the base portion, from the first emission laser beams reflected by the plurality of first mirrors and generate second parallel laser beams propagating in a direction parallel to the placement surface of the base portion, from the second emission laser beams reflected by the plurality of second mirrors;
an optical combiner portion configured to combine the first parallel laser beams and the second parallel laser beams with each other to generate combined laser beams; and
a focusing portion configured to focus and couple the combined laser beams to the optical fiber.

2. The laser module as recited in claim 1, wherein an optical path length from the first semiconductor laser device of each of the plurality of first laser sections to the optical parallelization portion is equal to an optical path length from the second semiconductor laser device of a corresponding one of the plurality of second laser sections to the optical parallelization portion.

3. The laser module as recited in claim 1 or 2, wherein an optical axis of the first emission laser beam emitted from the first semiconductor laser device of each of the plurality of first laser sections lies on a same line as an optical axis of the second emission laser beam emitted from the second semiconductor laser device of a corresponding one of the plurality of second laser sections.

4. The laser module as recited in any one of claims 1 to 3, wherein the optical parallelization portion is formed of a single member.

5. The laser module as recited in any one of claims 1 to 4, wherein the optical parallelization portion, the optical combiner portion, and the focusing portion are arranged on the placement surface of the base portion.

6. The laser module as recited in any one of claims 1 to 5, further comprising an auxiliary mirror configured to reflect the second emission laser beams or the second parallel laser beams toward the optical combiner portion.

7. A fiber laser apparatus comprising:
at least one pumping light source including the laser module as recited in any one of claims 1 to 6; and
an amplification optical fiber connected to the optical fiber of the laser module, the amplification optical fiber having a core to which rare earth ions have been doped.
